# FASCICULE DE BREVET EUROPEEN

(11) **EP 2 457 234 B1**
(45) Date de publication et mention de la délivrance du brevet: **05.09.2018**
(21) Numéro de dépôt: 10734139.8
(22) Date de dépôt: 21.07.2010
(51) Int. Cl.: G11B 33/14

(54) **DISPOSITIF D'ACCUEIL POUR DISQUE DUR**
ANDOCKVORRICHTUNG FÜR EINE FESTPLATTE
DOCKING DEVICE FOR A HARD DISK

(30) Priorité: 24.07.2009 FR 0903652
(43) Date de publication de la demande: 30.05.2012
(73) Titulaire: SAGEMCOM BROADBAND SAS, 92500 Rueil Malmaison (FR)
(72) Inventeur: VENOM, Didier, F-92500 Rueil Malmaison (FR); SUSINI, Dominique, F-92500 Rueil Malmaison (FR); SONJON, Grégory, F-92500 Rueil Malmaison (FR)
(74) Mandataire: Beaudouin-Lafon, Emmanuel
(86) Numéro de dépôt international: PCT/EP2010/060552
(87) Numéro de publication internationale: WO 2011/009881

(56) Documents cités:
- WO-A2-2007/041186
- US-A- 5 694 294
- US-A- 6 141 214
- US-A1- 2002 051 338
- US-A1- 2005 240 949
- US-A1- 2006 067 046
- US-A1- 2006 274 498
- US-A1- 2007 047 202

## Description

La présente invention concerne un dispositif d'accueil d'un disque dur et l'équipement électronique équipé d'un tel dispositif. Un tel équipement est par exemple un équipement audiovisuel, comme un décodeur ou un lecteur optique de disque du type DVD, destiné à être relié à un téléviseur et comportant une fonctionnalité d'enregistrement de données, notamment d'enregistrements télévisuels ou audiovisuels, sur disque dur. Le disque dur peut être prévu extractible sans démontage de l'équipement.

Généralement, ce type de dispositif comporte un boîtier délimitant un logement dans lequel est disposée une carte à circuit imprimée sur laquelle sont montés différents composants électroniques. C'est généralement aussi sur la carte que sont montés le ou les composants permettant d'insérer le disque dur, d'en assurer les connexions électriques et électroniques appropriées et l'extraction aisée quand le disque dur est prévu extractible. Le boîtier assure la protection mécanique de l'ensemble de ces composants et confère également au dispositif un caractère compact et esthétique.

Certains au moins des composants contenus dans le boîtier sont susceptibles de s'échauffer en fonctionnement normal, et il est donc utile de prévoir des moyens d'échange thermique entre l'intérieur du boîtier et son environnement extérieur afin d'assurer leur refroidissement. Ces moyens d'échange thermique peuvent être, notamment, des ouvertures d'aération pratiquées dans les parois du boîtier éventuellement associés à des moyens de ventilation forcé (ventilateurs), l'utilisation d'un boîtier dont les parois sont au moins partiellement en matériau conducteur thermique, du type métallique, voire l'utilisation de radiateurs à ailettes.

US5694294 décrit un tel arrangement. Le fait que ce type de dispositif soit susceptible de contenir un disque dur ajoute une contrainte supplémentaire sur le plan thermique, dans la mesure où le disque dur a également tendance à s'échauffer et qu'il est nécessaire de le maintenir à une température de fonctionnement généralement inférieure à la température de fonctionnement des autres composants électroniques, notamment du micro-processeur. Il faut donc un système de refroidissement particulièrement performant.

Or, les diverses solutions techniques évoquées plus haut ne sont pas optimales.

En effet, il n'est pas toujours souhaitable de pratiquer des ouvertures d'aération là où elles seraient, sur le plan thermique, les plus avantageuses, par exemple sur le dessus du boîtier, ceci pour des raisons esthétiques ou pour éviter l'empoussièrage de l'intérieur du boîtier.

De même, utiliser des radiateurs à ailettes est efficace sur le plan thermique, mais pas envisageable pour les mêmes raisons esthétiques et de risque d'empoussiérage.

Enfin, si le recours à des ventilateurs pour induire une convection forcée d'air dans le boîtier est utile, leur configuration ne permet pas toujours un refroidissement efficace de l'ensemble des composants susceptibles de s'échauffer, tout particulièrement ceux qui se trouvent les plus éloignés du ventilateur. Et il n'est pas toujours possible, notamment pour des raisons d'encombrement, d'utiliser des ventilateurs plus puissants, car ils sont alors généralement de taille trop importante.

L'invention a alors pour but de remédier aux inconvénients des solutions antérieures pour refroidir les composants susceptibles de s'échauffer dans ce type de dispositif. L'invention vise notamment la mise au point de moyens de refroidissement améliorés, efficaces sur le plan thermique et qui préservent l'esthétisme et la propreté du dispositif en usage normal.

L'invention a pour objet un dispositif d'accueil pour disque dur, comme défini dans la revendication 1. L'invention propose ainsi de refroidir simultanément la face supérieure et la face inférieure de la carte à circuit imprimé, et ceci avec un seul moyen de ventilation, ce qui permet d'augmenter l'efficacité du refroidissement de la carte et des composants qu'elle porte sans complexifier le dispositif, et, de fait, en pouvant alors se permettre de supprimer les ouvertures pratiquées sur le dessus du dispositif sans préjudice notable sur le plan thermique. Les moyens de guidage associés au moyen de ventilation assurent qu'une portion de ce flux d'air va bien refroidir le disque dur quand il est inséré dans le dispositif, ce qui rend le ventilateur plus efficace dans son action de refroidissement sans avoir à le sur-dimensionner.

Avantageusement, des composants électroniques sont montés sur la carte à circuit imprimé et des moyens de guidage sont également prévus pour guider au moins une partie du flux d'air vers au moins un de ces composants électroniques, notamment un micro-processeur et un tuner.

Ces différents moyens de guidage sont avantageusement des aménagements du boitier et de la carte qui permettent de canaliser et/ou d'évacuer l'air projeté dans le boitier par le ventilateur : il s'agit notamment d'ouvertures et d'éléments protubérants du type nervures ou déflecteurs, ou encore des reliefs du type marche/rampe disposés dans les parois internes du boitier, et aussi d'ouvertures pratiquées au niveau de la carte à circuit imprimé elle-même.

De préférence, le ventilateur est du type axial à hélice actionnée par un moteur électrique, et l'hélice du ventilateur est disposée dans un plan sensiblement perpendiculaire au plan médian de la carte à circuit imprimé. On peut ensuite ajuster la hauteur relative de l'hélice par rapport à la carte pour répartir de façon précise le flux d'air en deux flux de part et d'autre de la carte.

Avantageusement, au moins 60%, notamment entre 70 et 90% du flux d'air émis par le moyen de ventilation balaie une des faces principales, notamment la face supérieure, de la carte à circuit imprimé. C'est en effet préférable que ce soit la face supérieure qui soit en contact avec le flux d'air de refroidissement le plus important, pour au moins deux raisons : d'une part, c'est généralement sur la face supérieure de la carte que sont montés les composants électroniques que l'on cherche à refroidir. D'autre part, notamment du fait de l'encombrement dans le boîtier dû à la connectique, il est plus aisé de disposer la carte au fond du boîtier.

De préférence, le boîtier comprend au moins une ouverture ménagée dans une seconde paroi en regard de la première paroi.

De préférence encore, la carte à circuit imprimée est munie d'au moins une ouverture traversante d'aération autorisant le passage d'au moins une partie du flux d'air émis par le moyen de ventilation.

De préférence, une au moins des ouvertures traversantes d'aération de la carte à circuit imprimé est en regard d'au moins une ouverture ménagée dans une paroi du boîtier.

Les déflecteurs peuvent être ménagés dans la paroi supérieure du boîtier et se trouver à distance de la face supérieure de la carte à circuit imprimé.

Avantageusement, les composants électroniques sont montés sur la carte à circuit imprimé, et les nervures et/ou déflecteurs sont aptes à amener une partie au moins du flux d'air émis par le moyen de ventilation vers l'emplacement du disque dur et/ou vers un ou plusieurs desdits composants électroniques. On vient ainsi guider, par des aménagements sur la paroi interne du boîtier, le flux d'air de refroidissement vers les zones qui en ont le plus besoin.

De préférence, le boîtier a une forme sensiblement parallélépipédique, avec une paroi inférieure et une paroi supérieure en regard des faces principales de la carte à circuit imprimé, la paroi supérieure du boîtier étant dépourvue d'ouverture(s) traversante(s) d'aération.

Selon un mode de réalisation, le boîtier a une forme sensiblement parallélépipédique, le moyen de ventilation étant posé sur la paroi inférieure du boîtier et monté dans une ouverture pratiquée dans une paroi latérale dudit boîtier, ladite paroi inférieure présentant une marche et/ou une rampe ascendante en vis-à-vis dudit ventilateur. La rampe et/ou la marche peuvent être délimitées par des nervures, afin de cantonner au moins pour partie le flux d'air et contrôler son écoulement dans le boîtier.

D'autres caractéristiques et avantages de l'invention ressortiront à la lecture de la description qui suit d'un mode de réalisation particulier non limitatif de l'invention.

Il sera fait référence aux dessins annexés, parmi lesquels :
- la figure 1 est une vue schématique en perspective de la demi-coque inférieure d'un boîtier de protection d'un dispositif d'accueil de disque dur selon l'invention ;
- la figure 2 est une vue schématique en perspective de la demi-coque supérieure d'un boîtier de protection d'un dispositif d'accueil de disque dur selon l'invention ;
- la figure 3 est une vue schématique en perspective de la demi-coque inférieure selon la figure 1, une fois équipée de la carte imprimée munie de ses composants électroniques et de ses moyens de connexion électrique ;
- la figure 4 est à nouveau une vue de la demi-coque inférieure selon la figure 3, où la carte à circuit imprimé a été également munie d'un support de disque dur extractible, la demi-coque inférieure étant alors prête à être assemblée avec la demi-coque supérieure selon la figure 2.

L'ensemble des figures est schématique et ne respecte pas nécessairement l'échelle entre les différents composants représentés afin d'en faciliter la lecture, chaque élément représenté conservant la même référence dans l'ensemble des figures.

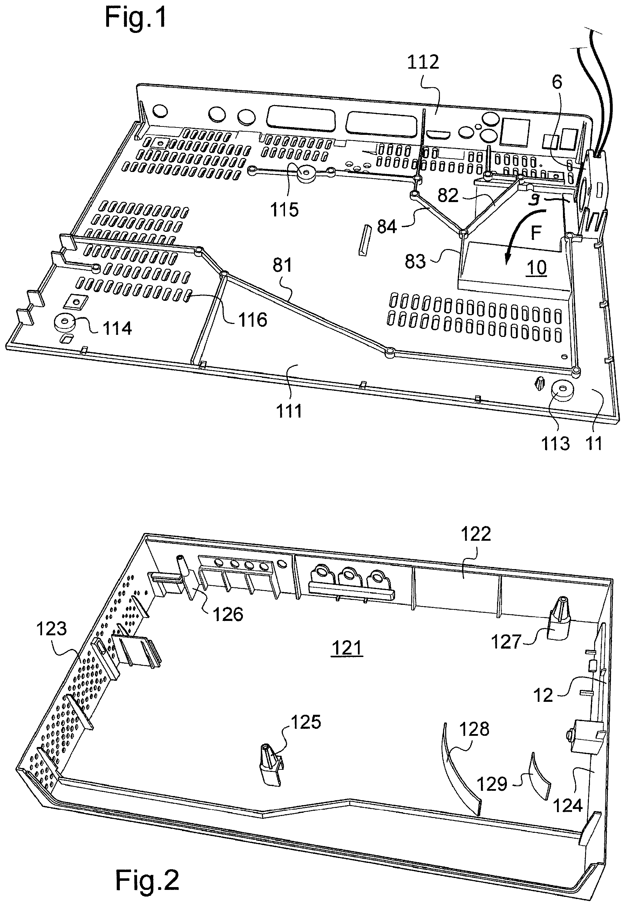

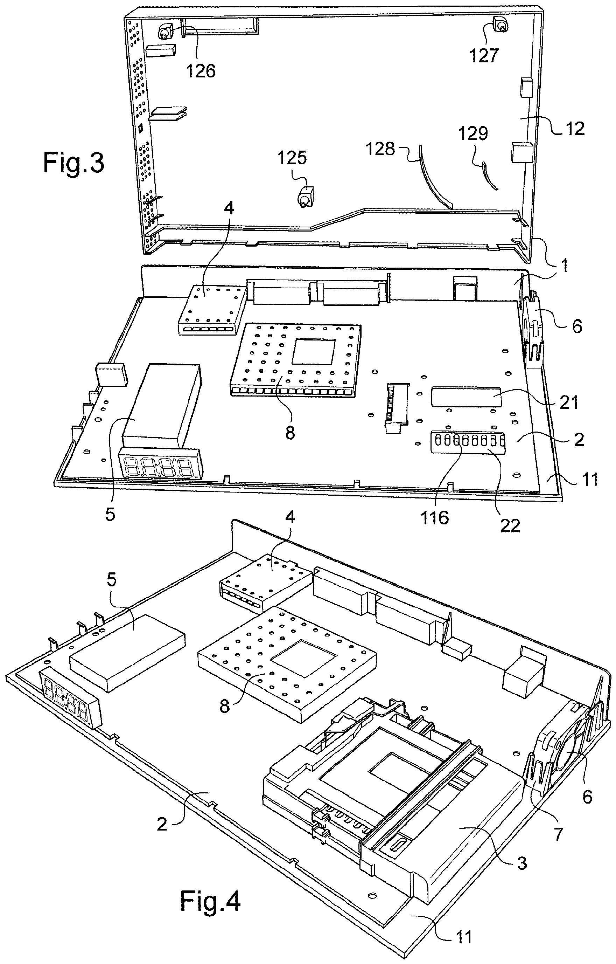

En référence aux figures 1 à 4, le dispositif d'accueil conforme à l'invention comprend un boîtier 1 équipé d'une carte à circuit imprimé 2 sur laquelle sont montés différents composants électroniques/électriques. Le dispositif est en outre destiné à recevoir un disque dur extractible, non représenté, par insertion dans support sous forme d'un composant à glissières 3 monté sur la carte 2 (figure 4). Le boîtier comprend une première demi-coque 11 dite inférieure et une deuxième demi-coque 12 dite supérieure qui sont pourvues de moyens de solidarisation l'une à l'autre en définissant l'espace de réception du disque dur et de la carte à circuit imprimé 2 et ses composants électroniques/électriques.

Dans la présente demande, les termes « supérieur », « inférieur » , « latéral », « haut » ou « bas » font référence à la position des composants du dispositif selon l'invention, tels qu'ils sont disposés en mode de fonctionnement normal, et se comprennent à la lecture des figures pour en faciliter la description, sans avoir un caractère limitatif.

La demi-coque inférieure 11 comprend ici une paroi inférieure 111 et une paroi de fond 112, alors que la demi-coque supérieure 12 comprend une paroi supérieure 121, une paroi avant 122 et deux parois latérales 123,124 et, de façon à ce que, une fois assemblées, les deux-demi coques 11,12 définissent un boîtier 1 de forme sensiblement parallélépipédique. Elles sont ici en matériau polymère, notamment thermoplastique du type polyéthylène, ou polyamide, ou acrylonitrile-butadiène-styrène, et obtenues de façon connue par moulage par injection. Cette technique est intéressante, car elle permet l'obtention de formes complexes de façon nettement plus facile que, par exemple, par des techniques d'emboutissage de tôle. Comme cela sera détaillé plus avant, elle se révèle particulièrement intéressante dans le cadre de l'invention, car elle permet l'obtention sans difficulté de boîtiers avec des rainures, des marches, des éléments saillants, des nervures...

L'assemblage des deux demi-coques 11,12 se fait par vissage de vis (non représentées) à travers la demi-coque supérieure 12 par les trois fûts de vissage 125,126,127 prévus sur sa face supérieure 121 qui sont en correspondance, en position d'assemblage, avec trois orifices non représentés ménagés dans la carte à circuit imprimée 2 et avec trois orifices 113,114,115 ménagés sur la face inférieure 111 de la demi-coque inférieure 11.

Comme évoqué plus haut, un certain nombre de composants électroniques sont montés sur la carte à circuit imprimé 2. Il s'agit notamment d'un microprocesseur non visible aux figures et destiné à être muni d'un radiateur puis inséré dans un boîtier métallique ajouré 8 monté sur la carte 2, le boîtier métallique assurant le blindage électromagnétique du microprocesseur, et d'un tuner également non visible aux figures et protégé par un boîtier métallique ajouré 4 afin d'en assurer le blindage électromagnétique. On comprend, de façon connue, sous le terme de tuner des moyens d'émission et/ou de réception de signaux. Outre la carte elle-même, le tuner et le microprocesseur sont notamment les deux composants électroniques les plus susceptibles de s'échauffer en fonctionnement normal, ainsi que le disque dur quand celui-ci est inséré dans son support 3.

Il est également monté sur la carte 2 un lecteur de carte à puce 5, et d'autres composants non décrits en détails ici.

Il est donc utile de prévoir un système de ventilation intégré au dispositif, qui puisse refroidir efficacement la carte 2 et les composants montés sur la carte les plus susceptibles de s'échauffer, notamment le microprocesseur, le tuner et le disque dur, sans pour autant nuire à l'esthétique du dispositif.

Le système de ventilation selon ce mode de réalisation de l'invention comprend les éléments suivants : un ventilateur 6 et des aménagements prévus dans les parois du boîtier 1 et au niveau de la carte à circuit imprimé 2, aménagements, comme cela sera détaillé par la suite, comprenant des éléments saillants et des ouvertures dans les parois du boîtier 1 et des ouvertures dans la carte à circuit imprimé 2.

Le ventilateur 6, de façon connue, est un moto-ventilateur utilisant un moteur électrique apte à faire tourner une hélice autour de son axe. On appelle également ce type de ventilateur sous le terme de ventilateur axial. Ce ventilateur est posé sur la paroi interne inférieure 111 de la demi-coque inférieure 11 et monté dans une ouverture pratiquée sur la paroi latérale 124 de la demi-coque supérieure 12. Le montage s'effectue à l'aide de montants latéraux 7 faisant partie de la paroi inférieure 111 et munis de rainures qui permettent d'encliqueter le ventilateur 6 sans nécessiter d'outillage particulier. Sur la paroi latérale 123 en regard, et opposée à la paroi latérale 124 dans lequel est monté le ventilateur 6, il est prévu des ouvertures d'aération (non représentés) sous forme de petits trous répartis sur une partie au moins de la paroi en question.

L'air de refroidissement est donc prélevé par le ventilateur 6 à l'extérieur du boîtier 1 par l'ouverture dans laquelle il est monté. Le flux d'air envoyé par le ventilateur 6 dans le boîtier 1 peut donc, au moins en partie, s'évacuer par ces ouvertures disposées en regard de celui-ci.

La carte à circuit imprimé 2 est montée dans la demi-coque inférieure 11 et repose sur un ensemble de nervures saillantes 81,82,83,84 sur la paroi interne inférieure 111 de la demi-coque inférieure 11.

Le ventilateur 6 est posé sur la paroi inférieure 111 de la demi-coque inférieure 11, dans une zone située à un niveau plus bas que le reste de la paroi inférieure 111. Au voisinage immédiat du ventilateur 6, il est prévu une marche 9, puis une rampe ascendante 10 (figure 1), délimitée latéralement par deux des nervures 82,83 évoquées plus haut, et s'achevant par un seuil.

Le ventilateur 6 est disposé par rapport à la carte à circuit imprimé 2 de façon à projeter un flux d'air contre l'un des bords de la carte 2 : l'hélice du ventilateur est disposée sensiblement perpendiculairement au plan médian de la carte. La hauteur relative de l'hélice du ventilateur par rapport à celle de la carte dans le boîtier et la configuration de la marche et de la rampe évoquées plus haut sont ajustées de façon à ce qu'environ 60 à 70% du flux d'air projeté par l'hélice vienne balayer la face supérieure de la carte 2 (il sera désigné par la suite sous le terme de flux d'air supérieur) et que le reste du flux d'air (qui sera désigné par la suite sous le terme de flux d'air inférieur) vienne balayer la face inférieure de la carte 2.

Les nervures 82,83 délimitant la rampe 10 ont en fait deux fonctions : d'une part, comme le reste des nervures dont est pourvue la paroi inférieure 111 de la demi-coque inférieure 11, elles servent de support à la carte imprimée 2. Et d'autre part, elles servent aussi à canaliser, guider la portion du flux d'air émis par le ventilateur 6 qui vient balayer la face inférieure de la carte 2. En effet, si on se rapporte plus particulièrement aux figures 1 et 3, on peut visualiser l'écoulement du flux d'air inférieur le long de la face inférieure de la carte 2 : le flux d'air inférieur suit la rampe 10 en effectuant un virage à 90° par rapport à son axe d'émission initial par l'hélice (flèche F, figure 1), puis, une fois le seuil atteint, il remonte (ou tout au moins une portion de celui-ci) par une première ouverture traversante 21 pratiquée dans la carte 2 (figure 3). Une fois parvenu sur la face supérieure de la carte 2, il va rejoindre le flux d'air supérieur, et une portion de ces flux est ensuite prélevée par l'autre ouverture 22 pratiquée dans la carte 2.

Comme visible dans la figures 3 et 4, les ouvertures 21 et 22 sont situées en vis-à-vis du support de disque dur 3, de sorte que l'air admis par l'ouverture 21 et évacué par l'ouverture 22 longe la face inférieure du disque dur pour optimiser son refroidissement. Concrètement, l'air admis par l'ouverture 21 circule entre la face inférieure du disque dur et la face supérieure de la carte 2 avant d'être évacué par l'ouverture 22.

Comme cette autre ouverture 22 est en regard de petites ouvertures 116 organisées en deux rangées dans la paroi inférieure 111 de la demi-coque inférieure 11, l'air ainsi prélevé peut traverser ou retraverser la carte 2 pour être évacué par ces ouvertures 115 hors du boîtier 1. Une autre partie du flux d'air inférieur continue sa route à la surface de la face inférieure de la carte 2, guidée par les nervures convergentes 81,84 afin de refroidir de façon privilégiée les zones de la carte 2 où sont montés respectivement le microprocesseur et le tuner. Enfin, la portion du flux d'air inférieur qui parvient à la paroi latérale 123 opposée à la paroi 124 où est monté le ventilateur 6, est, comme déjà mentionné, au moins pour partie évacuée par les ouvertures pratiquées dans ladite paroi. Il est à noter que la paroi inférieure 111 de la demi-coque inférieure 11 contient aussi plusieurs rangées d'ouvertures d'aération 116 à proximité de cette paroi latérale 123, par lesquelles une portion du flux d'air inférieur est aussi susceptible de s'échapper hors du boîtier 1.

Considérons maintenant le flux d'air supérieur. Celui ci balaie la face supérieure de la carte 2. Une portion de celui-ci est canalisée par deux déflecteurs 128,129 (figure 2) disposés sur la face interne de la face supérieure 121 de la demi-coque supérieure 12. Ces déflecteurs sont des parois courbes, sensiblement concentriques, et d'une hauteur telle que leur extrémité reste à distance de la face supérieure de la carte 2. La veine du flux d'air la plus proche de la paroi de la demi-coque est donc amenée par les déflecteurs 128,129 à converger vers l'emplacement 3 du support de disque dur extractible afin de refroidir le disque dur quand celui-ci est inséré dans ledit support. Le reste du flux d'air supérieur poursuit sa route sur la face supérieure de la carte 2, et parvient à la paroi latérale 123 opposée à la paroi 214 où est monté le ventilateur 6 : tout comme pour le flux d'air inférieur, il est alors évacué au moins pour partie par les ouvertures pratiquées dans ladite paroi latérale 123.

Il est à noter que, par ailleurs et de façon connue, le boîtier 1 selon l'invention est muni d'ouvertures destinées à s'étendre en regard de surfaces de reprise de masse ménagées à la surface du disque dur une fois inséré dans son support. De façon connue également, la paroi de fond 122 est munie de diverses ouvertures, nécessaires notamment à faire passer les éléments de connexion électrique.

Bien entendu, l'invention n'est pas limitée au mode de réalisation décrit et on peut y apporter des variantes de réalisation sans sortir du cadre de l'invention tel que défini par les revendications.

Ainsi, les demi-coques 11,12 constituant le boîtier 1, ou au moins une d'entre elles, peuvent alternativement être réalisées en métal. Elles peuvent aussi présenter une configuration différente, notamment la demi-coque inférieure pourrait porter, à la place de la demi-coque supérieure, au moins une, deux ou trois des parois latérales 123,124 ou avant 122. La solidarisation des deux demi-coques 11,12 peut aussi être réalisée par d'autres moyens mécaniques que des vis, par exemple avec un système d'articulation, de glissières, par clipsage ou collage, etc ...

L'invention peut également s'appliquer à des dispositifs dont le disque dur n'est pas nécessairement extractible, ainsi qu'à des dispositifs qui ne sont pas prévus pour contenir des disques durs, qu'ils soient extractibles ou non. Dans ce dernier cas, on supprime ou adapte la configuration des moyens de guidage qui lui étaient plus particulièrement dédiés.

La configuration et la localisation sur l'une ou l'autre des demi-coques des nervures et des déflecteurs peut être adaptée en fonction des emplacements des éléments électroniques les plus susceptibles de s'échauffer sur la carte à circuit imprimé 2.

Il est à noter que le ventilateur se trouve à proximité de l'emplacement du disque dur, pour refroidir directement le disque dur. Au moins une partie du flux d'air projeté par le ventilateur est dirigé vers le disque dur pour le refroidir en premier lieu avant d'atteindre les composants électroniques tels que le processeur et le tuner. Ainsi, le flux d'air reçu par le disque dur n'a pas encore eu le temps de se réchauffer au contact de la carte 2 et des composants électroniques qu'elle porte. Mais d'autres configurations respectives entre le ventilateur 6 et l'emplacement 3 de disque dur sont bien sûr possibles.

La position du ventilateur 6 par rapport à la carte 2 peut aussi être ajustée afin de modifier la répartition entre flux d'air supérieur et inférieur.

## Revendications

1. Dispositif d'accueil pour un élément extractible tel qu'un disque dur, comprenant un boîtier de protection (1) dans lequel sont logés une unité électronique comprenant une carte à circuit imprimé (2), et un moyen de ventilation (6) disposé dans ou au voisinage d'une ouverture ménagée dans une première paroi (124) du boîtier de protection, ledit boîtier prévoyant également un emplacement (3) pour l'élément extractible, ledit moyen de ventilation (6) étant disposé au voisinage d'un bord de la carte imprimée (2) de façon à ce que le flux d'air émis par ledit moyen de ventilation balaie les deux faces principales de la carte à circuit imprimé (2), des moyens de guidage étant prévus pour guider directement au moins une partie d'un flux d'air supérieur et au moins une partie d'un flux d'air inférieur émis par le ventilateur vers l'emplacement (3) pour l'élément extractible,
l'une au moins des parois internes (111,121) du boîtier (1) en regard des faces principales de la carte à circuit imprimé (2) étant munie de nervures (81,82,83,84) et/ou de déflecteurs (128,129) aptes à modifier l'écoulement d'au moins une partie du flux d'air émis par le moyen de ventilation (6),
des nervures (81,82,83,84) étant ménagées dans la paroi inférieure (111) du boîtier (1) et étant en contact avec la face inférieure de la carte à circuit imprimé (2),
la carte à circuit imprimé comprenant une première ouverture traversante (21) permettant à au moins une partie du flux d'air inférieur guidée par les nervures de parvenir sur une face supérieure de la carte à circuit imprimée et de rejoindre le flux d'air supérieur, la carte à circuit imprimé comprenant une deuxième ouverture traversante (21) permettant d'évacuer une partie du flux d'air inférieur et une partie du flux d'air supérieur.

2. Dispositif selon la revendication précédente, **caractérisé en ce que** des composants électroniques sont montés sur la carte à circuit imprimé (2) et **en ce que** des moyens de guidage sont également prévus pour guider au moins une partie du flux d'air vers au moins un de ces composants électroniques, notamment un micro-processeur et un tuner.

3. Dispositif selon l'une des revendications précédentes, **caractérisé en ce que** le moyen de ventilation est un ventilateur (6) de type axial, comprenant un moteur électrique entraînant une hélice.

4. Dispositif selon la revendication précédente, **caractérisé en ce que** l'hélice du ventilateur (6) est disposée dans un plan sensiblement perpendiculaire au plan médian de la carte à circuit imprimé (2).

5. Dispositif selon l'une des revendications précédentes, **caractérisé en ce qu'**au moins 60%, notamment entre 70 et 90% du flux d'air émis par le moyen de ventilation balaie une des faces principales, notamment la face supérieure, de la carte à circuit imprimé (2).

6. Dispositif selon l'une des revendications précédentes, **caractérisé en ce que** le boîtier (1) comprend au moins une ouverture ménagée dans une seconde paroi (123) en regard de la première paroi (124).

7. Dispositif selon l'une des revendications précédentes, **caractérisé en ce que** la carte à circuit imprimé (2) est munie d'au moins une ouverture traversante d'aération (21,22) autorisant le passage d'au moins une partie du flux d'air émis par le moyen de ventilation (6).

8. Dispositif selon la revendication précédente, **caractérisé en ce qu'**une au moins des ouvertures traversantes d'aération (22) de la carte à circuit imprimé est en regard d'au moins une ouverture (115) ménagée dans une paroi (111) du boîtier (1).

9. Dispositif selon la revendication 1, **caractérisé en ce que** des déflecteurs (128,129) sont ménagés dans la paroi supérieure (121) du boîtier (1) et sont à distance de la face supérieure de la carte à circuit imprimé (2).

10. Dispositif selon la revendication 1, **caractérisé en ce que** des composants électroniques sont montés sur la carte à circuit imprimé (2), et **en ce que** les nervures (81,82,83,84) et/ou déflecteurs (128,129) sont aptes à amener une partie au moins du flux d'air émis par le moyen de ventilation (6) vers l'emplacement (3) de l'élément extractible et/ou vers un ou plusieurs desdits composants électroniques.

11. Dispositif selon l'une des revendications précédentes, **caractérisé en ce que** le boîtier (1) a une forme sensiblement parallélépipédique, avec une paroi inférieure (111) et une paroi supérieure (121) en regard des faces principales de la carte à circuit imprimé (2), la paroi supérieure (121) du boîtier étant dépourvue d'ouverture traversante d'aération.

12. Dispositif selon l'une des revendications précédentes, **caractérisé en ce que** le boîtier (1) a une forme sensiblement parallélépipédique, le moyen de ventilation (6) étant posé sur la paroi inférieure (111) du boîtier et monté dans une ouverture pratiquée dans une paroi latérale (124) dudit boîtier, ladite paroi inférieure présentant une marche (9) et/ou une rampe (10) ascendante en vis-à-vis dudit moyen de ventilation (6).

13. Dispositif selon la revendication précédente, **caractérisé en ce que** la rampe (10) et/ou la marche (9) est délimitée par des nervures (82,83).

## Patentansprüche

1. Aufnahmevorrichtung für ein herausziehbares Element, wie z. B. eine Festplatte, umfassend ein Schutzgehäuse (1), in dem eine elektronische Einheit, die eine Leiterplatte (2) umfasst, sowie ein Ventilationsmittel (6) untergebracht sind, das in oder nahe einer Öffnung angeordnet ist, die in einer ersten Wand (124) des Schutzgehäuses ausgebildet ist, wobei das Gehäuse ferner eine Stelle (3) für das herausziehbare Element vorsieht, wobei das genannte Ventilationsmittel (6) nahe einem Rand der Leiterplatte (2) derart angeordnet ist, dass der Luftstrom, der von dem genannten Ventilationsmittel abgegeben wird, die beiden Hauptflächen der Leiterplatte (2) überstreicht, wobei Führungsmittel vorgesehen sind, um mindestens einen Teil eines oberen Luftstroms und mindestens einen Teil eines unteren Luftstroms, die von dem Ventilator abgegeben werden, direkt in Richtung der Stelle (3) für das herausziehbare Element zu leiten, wobei mindestens eine der Innenwände (111, 121) des Gehäuses (1) gegenüber den Hauptflächen der Leiterplatte (2) mit Rippen (81, 82, 83, 84) und/oder Deflektoren (128, 129) versehen ist, die dazu geeignet sind, die Strömung mindestens eines Teils des Luftstroms, der von dem Ventilationsmittel (6) abgegeben wird, zu ändern, wobei Rippen (81, 82, 83, 84) in der unteren Wand (111) des Gehäuses (1) ausgebildet und in Kontakt mit der Unterseite der Leiterplatte (2) sind,
wobei die Leiterplatte eine erste Durchgangsöffnung (21) umfasst, die zumindest einem Teil des unteren Luftstroms, der von den Rippen geleitet wird, ermöglicht, auf eine obere Seite der Leiterplatte zu gelangen und wieder mit dem oberen Luftstrom zusammenzukommen, wobei die Leiterplatte eine zweite Durchgangsöffnung (21) umfasst, die ein Abführen eines Teils des unteren Luftstroms und eines Teils des oberen Luftstroms ermöglicht.

2. Vorrichtung nach dem vorhergehenden Anspruch, **dadurch gekennzeichnet, dass** die elektronischen Bauelemente auf der Leiterplatte (2) montiert sind und dass die Führungsmittel ferner vorsehen sind, um mindestens einen Teil des Luftstroms in Richtung mindestens eines dieser elektronischen Bauelemente zu lenken, insbesondere eines Mikroprozessors und eines Tuners.

3. Vorrichtung nach einem der vorhergehenden Ansprüche, **dadurch gekennzeichnet, dass** das Ventilationsmittel ein Ventilator (6) vom axialen Typ ist, der einen Elektromotor umfasst, der einen Propeller antreibt.

4. Vorrichtung nach dem vorhergehenden Anspruch, **dadurch gekennzeichnet, dass** der Propeller des Ventilators (6) in einer Ebene angeordnet ist, die im Wesentlichen senkrecht zur Mittelebene der Leiterplatte (2) ist.

5. Vorrichtung nach einem der vorhergehenden Ansprüche, **dadurch gekennzeichnet, dass** mindestens 60%, insbesondere zwischen 70 und 90% des Luftstroms, der von dem Ventilationsmittel abgegeben wird, eine der Hauptflächen, insbesondere die Oberseite der Leiterplatte (2) überstreicht.

6. Vorrichtung nach einem der vorhergehenden Ansprüche, **dadurch gekennzeichnet, dass** das Gehäuse (1) mindestens eine Öffnung umfasst, die in einer zweiten Wand (123) gegenüber der ersten Wand (124) ausgebildet ist.

7. Vorrichtung nach einem der vorhergehenden Ansprüche, **dadurch gekennzeichnet, dass** die Leiterplatte (2) mit mindestens einer Lüftungsdurchgangsöffnung (21, 22) versehen ist, die den Durchtritt mindestens eines Teils des von dem Ventilationsmittel (6) abgegebenen Luftstroms gestattet.

8. Vorrichtung nach einem der vorhergehenden Ansprüche, **dadurch gekennzeichnet, dass** sich mindestens eine der Lüftungsdurchgangsöffnungen (22) der Leiterplatte gegenüber mindestens einer Öffnung (115) befindet, die in einer Wand (111) des Gehäuses (1) ausgebildet ist.

9. Vorrichtung nach Anspruch 1, **dadurch gekennzeichnet, dass** Deflektoren (128, 129) in der oberen Wand (121) des Gehäuses (1) ausgebildet sind und einen Abstand zur Oberseite der Leiterplatte (2) haben.

10. Vorrichtung nach Anspruch 1, **dadurch gekennzeichnet, dass** elektronische Bauelemente auf der Leiterplatte (2) montiert sind und dass die Rippen (81, 82, 83, 84) und/oder Deflektoren (128, 129) dazu geeignet sind, mindestens einen Teil des von dem Ventilationsmittel (6) abgegebenen Luftstroms in Richtung der Stelle (3) des herausziehbaren Elements und/oder in Richtung einer oder mehrerer der genannten elektronischen Bauelemente zu leiten.

11. Vorrichtung nach einem der vorhergehenden Ansprüche, **dadurch gekennzeichnet, dass** das Gehäuse (1) eine im Wesentlichen parallelepipedische Form hat, mit einer unteren Wand (111) und einer oberen Wand (121) gegenüber den Hauptflächen der Leiterplatte (2), wobei die obere Wand (121) des Gehäuses ohne eine Lüftungsdurchgangsöffnung ist.

12. Vorrichtung nach einem der vorhergehenden Ansprüche, **dadurch gekennzeichnet, dass** das Gehäuse (1) eine im Wesentlichen parallelepipedische Form hat, wobei das Ventilationsmittel (6) auf der unteren Wand (111) des Gehäuses angeordnet und in einer Öffnung angebracht ist, die in einer Seitenwand (124) des Gehäuses ausgebildet ist, wobei die genannte untere Wand eine Stufe (9) und/oder eine aufsteigende Rampe (10) aufweist, die dem genannten Ventilationsmittel (6) gegenüberliegen.

13. Vorrichtung nach dem vorhergehenden Anspruch, **dadurch gekennzeichnet, dass** die Rampe (10) und/oder die Stufe (9) von Rippen (82, 83) begrenzt wird.

## Claims

1. A docking device for a removable device such as a hard disk, the device comprising a protective box (1) housing an electronic unit including a printed circuit card (2) and fan means (6) arranged in or in the vicinity of an opening formed in a first wall (124) of the protective box, said box also providing a location (3) for the removable device, said fan means (6) being arranged in the vicinity of an edge of the printed circuit card (2) so that the air stream driven by said fan means sweeps over both main faces of the printed circuit card (2), guiding means being designed to guide at least a portion of a top air stream and at least a portion of a bottom air stream driven by the fan directly to the location (3) for the removable device,
at least one of the inside walls (111, 121) of the box (1) facing the main faces of the printed circuit card (2) is provided with ribs (81, 82, 83, 84) and/or deflectors (128, 129) suitable for modifying the flow of at least a portion of the air stream driven by the fan means (6), ribs (81, 82, 83, 84) projecting from the bottom wall (111) of the box (1) and being in contact with the bottom face of the printed circuit card (2),
the printed circuit card (2) being provided with a first ventilation through opening (21) allowing at least a portion of the bottom air stream guided by the ribs to pass through to reach the top face of the printed circuit card (2) and rejoin the top air stream, the printed circuit card (2) being provided with a second ventilation opening (22) allowing a portion of the bottom air stream and a portion of the top air stream to pass through.

2. A device according to the preceding claim, wherein electronic components are mounted on the printed circuit card (2), and wherein guide means are also provided for guiding at least a portion of the air stream towards at least one of said electronic components, in particular a microprocessor and a tuner.

3. A device according to any preceding claim, wherein the fan means (6) comprise an axial type fan comprising an electric motor driving a propeller.

4. A device according to the preceding claim, wherein the propeller of the fan (6) is arranged in a plane that is substantially perpendicular to the midplane of the printed circuit card (2).

5. A device according to any preceding claim, **characterized in that** at least 60%, in particular in the range 70% to 90%, of the stream of air driven by the fan means sweeps over one of the main faces of the printed circuit card (2), in particular its top face.

6. A device according to any preceding claim, **characterized in that** the box (1) includes at least one opening formed in a second wall (123) facing the first wall (124).

7. A device according to any preceding claim, **characterized in that** the printed circuit card (2) is provided with at least one ventilation through opening (21, 22) allowing at least a portion of the air stream driven by the fan means (6) to pass through.

8. A device according to the preceding claim, **characterized in that** at least one of the ventilation through openings (22) in the printed circuit card faces at least one opening (115) formed in a wall (111) of the box (1).

9. A device according to claim 1, **characterized in that** the deflectors (128, 129) project from the top wall (121) of the box (1) and are at a distance from the top face of the printed circuit card (2).

10. A device according to claim 1, **characterized in that** the electronic components are mounted on the printed circuit card (2), and **in that** the ribs (81, 82, 83, 84) and/or the deflectors (128, 129) are suitable for bringing at least a portion of the stream of air driven by the fan means (6) towards the location (3) for a removable device and/or towards one or more of said electronic components.

11. A device according to any preceding claim, **characterized in that** the box (1) is substantially in the shape of a rectangular parallelepiped, with a bottom wall (111) and a top wall (121) facing main faces of the printed circuit card (2), the top wall (121) of the box not having any ventilation through openings.

12. A device according to any preceding claim, **characterized in that** the box (1) is substantially in the form of a rectangular parallelepiped, the fan means (6) being placed on the bottom wall (111) of the box and mounted in an opening formed in a side wall (124) of said box, said bottom wall presenting a step (9) and/or a rising ramp (10) facing said fan means (6).

13. A device according to the preceding claim, **characterized in that** the ramp (10) and/or the step (9) is/are defined by ribs (82, 83).
